# EUROPÄISCHE PATENTSCHRIFT

(11) **EP 0 770 868 B1**
(45) Veröffentlichungstag und Bekanntmachung des Hinweises auf die Patenterteilung: **02.01.2002**
(21) Anmeldenummer: 96114961.4
(22) Anmeldetag: 18.09.1996
(51) Int. Cl.: G01N 21/88, G01N 21/55

(54) **Verfahren zur Kontrolle von Scheiben**
Process for controlling discs
Procédé de contrôle de disques

(30) Priorität: 25.10.1995 DE 19539735
(43) Veröffentlichungstag der Anmeldung: 02.05.1997
(73) Patentinhaber: Infineon Technologies AG, 81669 München (DE)
(72) Erfinder: Biedermann, Ernst, Dipl.-Phys., 93053 Regensburg (DE)
(74) Vertreter: Zedlitz, Peter, Dipl.-Inf.

(56) Entgegenhaltungen:
- EP-A- 0 678 911
- DE-A- 4 324 800
- US-A- 4 958 373
- US-A- 5 091 963
- PATENT ABSTRACTS OF JAPAN vol. 017, no. 504 (E-1430), 10.September 1993 & JP-A-05 129403 (TOSHIBA CORP), 25.Mai 1993,
- IMAGE AND SIGNAL PROCESSING IN ELECTRON MICROSCOPY, 6TH PFEFFERKORN CONFERENCE, NIAGARA FALLS, ONT., CANADA, 28 APRIL-2 MAY 1987, Bd. suppl., Nr. 2, ISSN 0891-7035, SCANNING MICROSCOPY, 1988, USA, Seiten 55-58, XP000650613 ROSENFELD A: "Shape (image processing)"

## Beschreibung

Die Erfindung betrifft ein Verfahren zur Kontrolle von Scheiben, die eine Lackschicht aufweisen, insbesondere einer Charge von solchen Scheiben. Eine Charge von Scheiben sind bekanntlich mehrere Scheiben, die Bestandteil eines einzigen Fertigungsloses sind. Bei den Scheiben kann es sich um verschiedene Arten von Scheiben handeln, z. B. um solche, die der Herstellung von Halbleiterbauelementen dienen wie integrierte Schaltungen oder Einzelhalbleiter oder aber auch um Scheiben, die der Herstellung einer Compact Disc ("CD", "CD-ROM") dienen. Bei dem Verfahren ist die Lackschicht, ggf. einschließlich darunterliegender Strukturen, auf einwandfreie Beschaffenheit zu kontrollieren. Dienen die Scheiben beispielsweise der Herstellung von Halbleiterbauelementen, so ist das Verfahren nach jedem Prozeßschritt notwendig und anwendbar, bei dem eine Lackschicht auf die Scheibe aufgebracht worden ist (dies ist bekanntlich mehrmals der Fall im Rahmen eines solchen Herstellungsprozesses). Dabei sollen fehlerhafte Scheiben erkannt werden, so daß sie vom weiteren Fertigungsablauf entweder ganz ausgeschlossen werden können oder aber, daß sie vor dem weiteren Fertigungsablauf entsprechend nachbearbeitet werden können und dann, Fehlerfreiheit vorausgesetzt (was wiederum eine Kontrolle der nunmehr nachbearbeiteten Scheiben voraussetzt), wieder in den normalen Fertigungsablauf eingeschleust werden können.

Solche Kontrollen von Scheiben auf einwandfreie Beschaffenheit (z. B. Kontrolle auf Partikelfreiheit, d. h. frei von Verschmutzungen und Ablagerungen, Kontrolle auf gleichmäßig dicke Lackschicht oder auf Fehlstellen bei der Lackschicht) ist bekanntlich eminent wichtig für das Erzielen guter Ausbeuten im Fertigungsprozeß.

Diese Kontrollen werden bislang manuell durchgeführt mit Hilfe von Mikroskopen oder ohne Mikroskop mittels schräg einfallendem Licht. Dies ist zum einen für das Personal sehr anstrengend, insbesondere für die Augen und den Rücken (Körperhaltung, stundenlanges Sitzen). Zum anderen ist es aber auch mit großen Unsicherheiten behaftet, weil beim Personal mit der Zeit die Konzentrationsfähigkeit nachläßt beim Erkennen von Fehlern und beim Sortieren nach guten und schlechten Scheiben.

In US-A 5091963 ist ein Verfahren und eine Vorrichtung offenbart zur Kontrolle von Oberflächen hinsichtlich vorhandener Unregelmäßigkeiten. Die Oberfläche wird beleuchtet, so daß Licht reflektiert wird. Ein Bild der Oberfläche wird bildpunktweise von einer optischen Vorrichtung aufgenommen und in einer digitalen Verarbeitungsvorrichtung analysiert. Anhand eines Vergleichs mit vorgegebenen Vergleichswerten wird beurteilt, ob die Oberfläche in Ordnung oder fehlerhaft ist.

Aufgabe der vorliegenden Erfindung ist es, den Vorgang des Kontrollierens möglichst fehlerfrei gestalten und die gesundheitlichen Belastungen des Personals reduzieren zu können.

In der prioritätsälteren, nicht vorveröffentlichten deutschen Patentanmeldung P 44 13 831.8 ist ein Verfahren beschrieben, mittels dem sich Scheiben mit einer Lackschicht, die der Herstellung integrierter Halbleiterspeicher dienen und die wenigstens eine erste Schicht mit Strukturen aufweisen, automatisch kontrollierbar sind. Dort sind auch Vorrichtungen beschrieben, mit denen dieses Verfahren ausgeführt werden kann. Diese Vorrichtungen und auch die Vorrichtungen nach der (ebenfalls prioritätsälteren, nicht vorveröffentlichten) deutschen Patentanmeldung P 44 13 832.6 sind auch zur Durchführung der vorliegenden Erfindung geeignet. Die Offenbarung dieser beiden älteren Patentanmeldungen ist auch insoweit Teil der Offenbarung der vorliegenden Erfindung, obwohl zum leichteren Verständnis des erfindungsgemäßen Verfahrens nachstehend teilweise noch wiederholt.

Diese Aufgabe wird beim erfindungsgemäßen Verfahren gelöst durch die Merkmale des Patentanspruches 1.

Vorteilhafte Aus- und Weiterbildungen sind in abhängigen Ansprüchen.

Die Erfindung wird nachstehend anhand einer Zeichnung näher erläutert. Dabei zeigen:
- die Figuren 1 bis 3: vorteilhafte Ausführungsformen von das Verfahren ermöglichenden Vorrichtungen,
- die Figuren 4 bis 9: Einzelheiten des erfindungsgemäßen Verfahrens.

Bevor das erfindungsgemäße Verfahren näher beschrieben wird, wird zunächst eine erste von für das Verfahren geeigneten Vorrichtungen kurz erläutert:

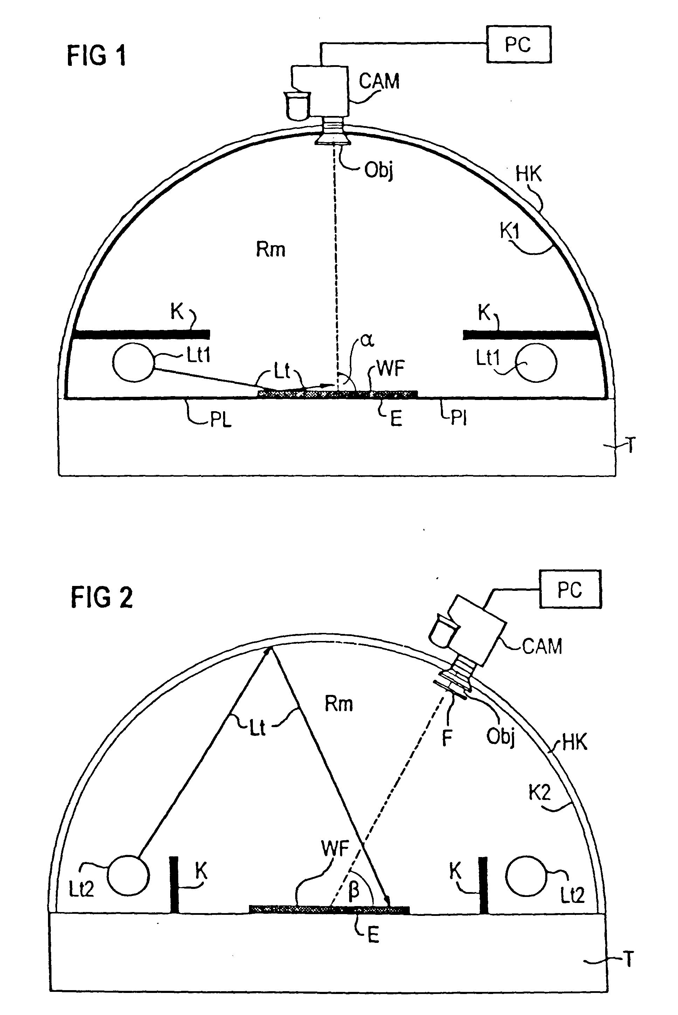

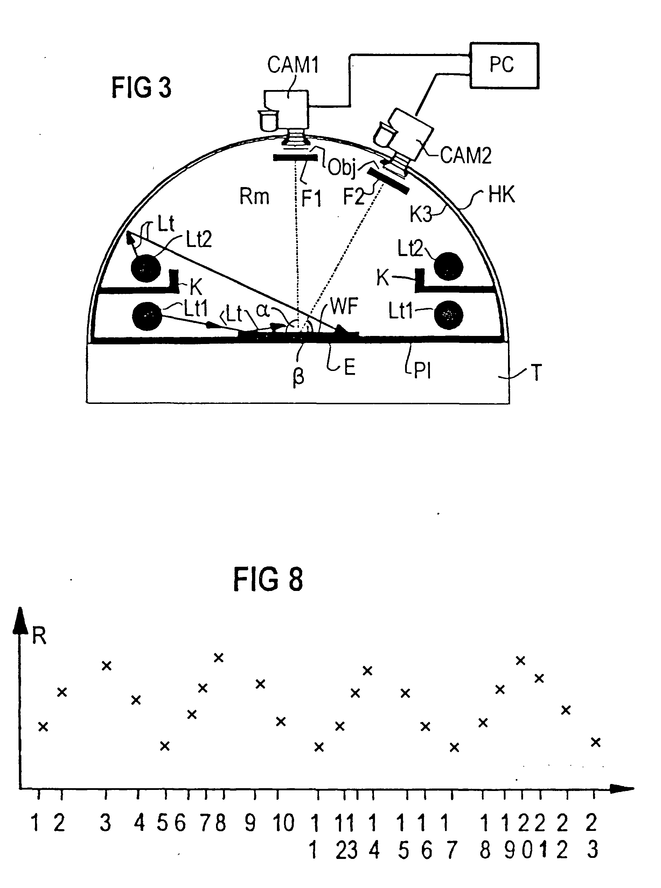

Figur 1 zeigt die Vorrichtung, die beispielsweise auf einem Tisch T (gilt auch für die weiteren beiden Vorrichtungen nach den Figuren 2 und 3) oder einer sonstigen geeigneten Unterlage mit festem Stand angeordnet sein kann. Die Vorrichtung weist eine Einrichtung E auf zur Aufnahme der zu kontrollierenden Scheibe WF sowie eine Bodenplatte Pl. Die Bodenplatte Pl ist jedoch nicht zwingend notwendig. Die Einrichtung E kann Bestandteil der Bodenplatte Pl sein. Sie kann aber auch, gemäß weiteren Ausgestaltungen der Vorrichtung, auf der Bodenplatte Pl angeordnet oder in diese eingelassen sein. Die Vorrichtung weist weiterhin eine halbkugelförmige Abdeckeinrichtung HK auf, welche mit der Bodenplatte Pl einen weitgehend geschlossenen Innenraum Rm bildet und die im Innenraum Rm eine auftreffendes Licht Lt weitgehend absorbierende Oberfläche K1 hat, die gegebenenfalls schwarz ist.

Innerhalb dieses Innenraumes Rm ist eine vorzugsweise, jedoch nicht unbedingt notwendigerweise ringförmige Beleuchtungseinrichtung Ltl angeordnet, die einer direkten Beleuchtung der zu kontrollierenden Scheibe WF dient. Die ringförmige Ausgestaltung ermöglicht eine gleichmäßige Beleuchtung der Scheibe WF. Die halbkugelförmige Abdeckeinrichtung HK weist innerhalb des abgeschlossenen Raumes Rm eine Oberfläche K1 auf, welche auftreffendes Licht Lt absorbiert.

Oberhalb der Beleuchtungseinrichtung Lt1 ist eine weitere Abdeckeinrichtung K angeordnet, welche auftreffendes Licht Lt nicht durchläßt und nach Möglichkeit absorbiert. Sie ist so ausgebildet, daß die Scheibe WF direkt beleuchtbar ist mittels der Beleuchtungseinrichtung Lt1, während die halbkugelförmige Abdeckung HK größtenteils gegenüber dem direkten Licht der Beleuchtungseinrichtung Lt1 abgedeckt ist. Infolge dieser Anforderungen ist es insbesondere bei ringförmiger Auslegung der Beleuchtungseinrichtung Lt1 günstig, auch die weitere Abdeckeinrichtung K ringförmig auszulegen.

In einem gegebenen Winkel α zur Einrichtung E zur Aufnahme der zu kontrollierenden Scheibe WF (und somit zu der zu kontrollierenden Scheibe WF selbst), vorzugsweise jedoch senkrecht dazu, ist an der halbkugelförmigen Abdeckeinrichtung HK eine Bildaufnahmeeinrichtung CAM, typischerweise eine Kamera, so angeordnet, daß ihr Objektiv Obj in den Innenraum Rm blickt, insbesondere auf die Stelle, an der sich im Betrieb die zu kontrollierende Scheibe WF befindet. Die Bildaufnahmeeinrichtung CAM kann dabei so angeordnet sein, daß ihr Objektiv Obj in den Innenraum Rm hineinragt, wie in Figur 1 dargestellt, oder aber auch so, daß der Rand ihres Objektives Obj in etwa bündig mit der halbkugelförmigen Abdeckung HK abschließt. Sie ist dazu bestimmt, von der Lackschicht L reflektiertes Licht Lt als Abbild der zu kontrollierenden Scheibe WF punktweise aufzunehmen.

Die Bildaufnahmeeinrichtung CAM ist mit einer Auswerteeinrichtung PC verbunden, die der Steuerung der Bildaufnahmeeinrichtung CAM dient sowie zum Empfang, zur Zwischenspeicherung, zur Verarbeitung und zur Ausgabe von von der Bildaufnahmeeinrichtung CAM übermittelten Daten ("Bildern"). Diese Daten können analog oder digital übermittelt werden, sofern die Bildaufnahmeeinrichtung CAM bereits für Digitalübermittlung ausgerüstet ist (z. B., wenn sie A/D-Wandler aufweist). Die Auswerteeinrichtung PC ist dabei typischerweise eine Rechnereinrichtung wie ein Personal Computer oder eine Datenverarbeitungsanlage. Es ist aber auch vorstellbar, daß sie ausschließlich aus Hardware gebildet ist, die das noch zu beschreibende Verfahren steuert.

U. a. folgende Ausgestaltungen der Vorrichtung sind möglich und günstig:

Die das Licht Lt absorbierende Oberfläche K1 der halbkugelförmigen Abdeckung HK ist schwarz.

Das von der Beleuchtungseinrichtung Lt1 ausgesandte Licht Lt ist weiß.

Die weitere Abdeckeinrichtung K hat eine schwarze Oberfläche.

Die Oberfläche der Bodenplatte Pl ist auf ihrer der halbkugelförmigen Abdeckeinrichtung HK zugewandten Seite schwarz.

Soweit sich im Innenraum Rm weitere Teile der Bildaufnahmeeinrichtung CAM befinden, so sind diese so angeordnet, daß sie, von der zu kontrollierenden Scheibe WF her betrachtet, durch das Objektiv Obj verdeckt sind.

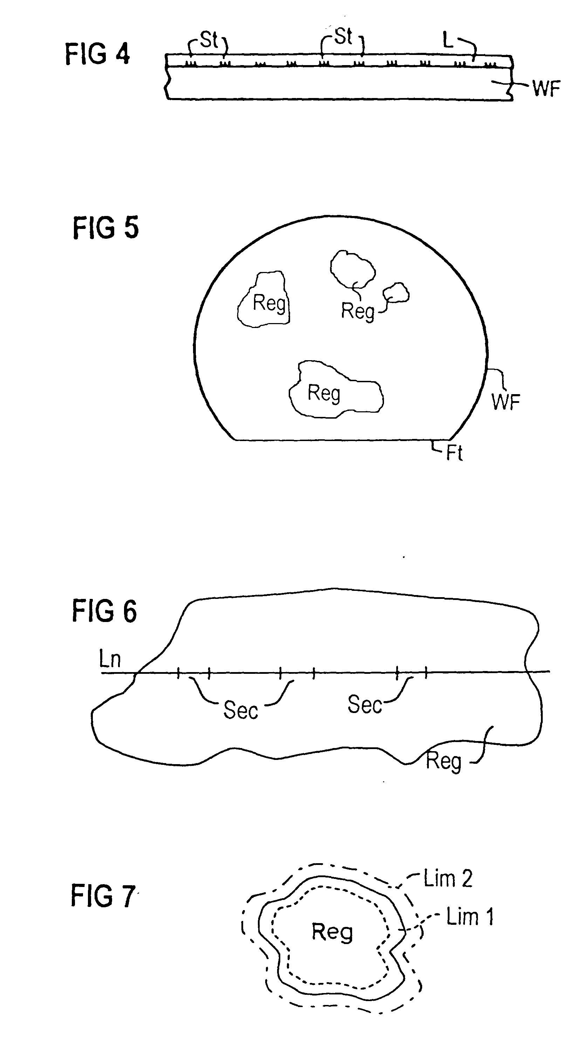

Mittels dieser Vorrichtung und ggf. seiner Weiterbildungen ist nun das nachstehend in Verbindung mit den Figuren 4 bis 9 beschriebene Verfahren durchführbar. Es ist geeignet zur Kontrolle sowohl einzelner Scheiben WF wie auch zur Kontrolle mehrerer bis aller Scheiben WF einer Charge von Scheiben WF (d. h. also, von Scheiben WF, die Bestandteil eines gemeinsamen Fertigungsloses sind).

Bei der Kontrolle werden Werte von Reflexionsgraden eines entsprechend reflektierten Lichtes einer anderen Scheibe (Vergleichsscheibe) als Vergleichswerte verwendet. Die Vergleichsscheibe ist bezüglich ihres Fertigungsstandes und ihres Typs identisch mit der zu kontrollierenden Scheibe WF. Der Lack und ggf. darunter liegende Strukturen der Vergleichsscheibe sind vorab als in Ordnung befunden worden.

Meist weisen Scheiben WF ein Orientierungsmerkmal auf (bei Halbleiterscheiben sind dies entweder aufgrund des aktuellen Fertigungsprozeßschrittes bereits vorhandene Strukturen St der Scheibe WF und/oder meist ein sogenanntes Flat Ft (d. h., ein Bereich der {in Draufsicht betrachtet} an sich runden Halbleiterscheibe WF ist abgeflacht). Beim Ausführungsbeispiel des nachstehenden Verfahrens wird davon ausgegangen, daß die zu kontrollierenden Scheiben WF ein solches Flat Ft (siehe Figur 5) oder ein anderes Orientierungsmerkmal wie Strukturen St (siehe Figur 4) aufweisen. Das Verfahren funktioniert jedoch auch dann, wenn die zu kontrollierende Scheibe WF kein Orientierungsmerkmal aufweist, da die Scheibe WF in diesem Fall, von oben betrachtet, uniform ist, d. h., das Abbild der Scheibe WF in der Bildaufnahmeeinrichtung CAM ist an jedem Bildpunkt Pixel gleich, sofern die Scheibe WF in Ordnung ist.

Ein wesentliches Merkmal des erfindungsgemäßen Verfahrens ist, daß die Kontrolle automatisch abläuft, d. h. ohne Zwischenschaltung menschlicher Tätigkeiten. Dies schont zum einen die Gesundheit des Personals (siehe eingangs geschilderte Nachteile zum Stand der Technik). Zum anderen fördert es aber auch die Genauigkeit der Kontrolle aus folgenden Gründen:
- Bei gleicher oder gar kürzerer Meßzeit (pro Scheibe) können mehr Meßpunkte kontrolliert werden, d. h. die Kontrolle ist genauer,
- Menschliche Fehlentscheidungen (Verwechseln der Erkennung von Gut/Ausfall und der Sortierung nach Gut/Ausfall) sind ausgeschlossen,
- Bei kürzerer Meßzeit pro Scheibe erhöht sich der Durchsatz, d. h. die Produktivität je Mitarbeiter.

Darüber hinaus eröffnet das erfindungsgemäße Verfahren auch die Möglichkeit, daß ein Mitarbeiter gleichzeitig mehrere Vorrichtungen, welche das erfindungsgemäße Verfahren durchführen, bedient (z. B. Auflegen und Abnehmen der Scheiben, soweit nicht automatisiert; Start des Verfahrens, soweit nicht automatisiert) und/oder kontrolliert, so daß die Produktivität nochmals erhöht werden kann (höhere Produktivität bedeutet bekanntlich niedrigere Herstellungskosten, was heutzutage eminent wichtig ist für Scheibenhersteller).

Das erfindungsgemäße Verfahren wird nun folgendermaßen durchgeführt (vgl. bezüglich der Vorrichtungen die Fig. 1, 3):

Die zu kontrollierende Scheibe WF wird mittels einer Beleuchtungseinrichtung Ltl direkt beleuchtet, so daß die Lackschicht L das auftreffende Licht Lt reflektiert. Die Bildaufnahmeeinrichtung CAM (bzw. CAM1 in Figur 3) erfaßt das Bild der Scheibe WF punktweise, wobei die Helligkeit jedes Bildpunktes Pixel der Bildaufnahmeeinrichtung CAM den Wert des Reflexionsgrades R des reflektierten Lichtes Lt repräsentiert, der sich an dem dem Bildpunkt Pixel entsprechenden Punkt der Oberfläche des Lackes L (und somit an einem Punkt der Scheibe WF) aufgrund der Beschaffenheit der Scheibe WF ergibt.

Wenigstens eine Mehrzahl der so ermittelten Werte des Reflexionsgrades R wird von der Bildaufnahmeeinrichtung CAM an die daran angeschlossene Auswerteeinrichtung PC übertragen und zwischengespeichert.

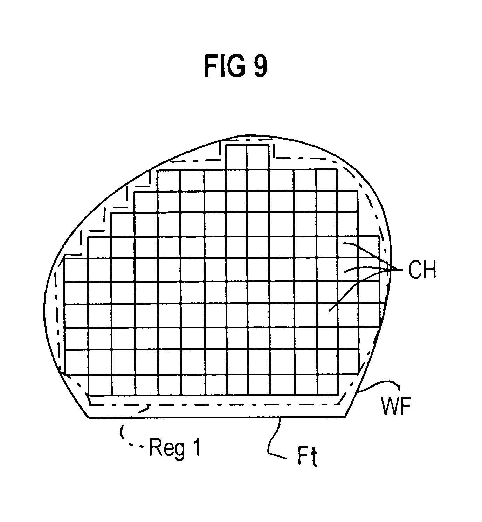

Für die Werte des Reflexionsgrads R ergibt sich beispielsweise der in Figur 8 dargestellte Verlauf (der nicht notwendigerweise eine Art Sinuskurve sein muß). Die Abszisse entspricht einer geometrischen Zuordnung der Bildpunkte Pixel zu Punkten der Scheibe WF (z. B. Koordinaten). Auf der Ordinate ist der jeweilige Wert des Reflexionsgrades R ablesbar.

Die so ermittelten und zwischengespeicherten Werte des Reflexionsgrades R werden jeweils mit einem der vorgegebenen Vergleichswerte, die ja von einer Vergleichsscheibe stammen und die ebenfalls in der Auswerteeinrichtung PC gespeichert sind, verglichen. Die Ergebnisse dieser Vergleiche werden wenigstens einem gegebenen Beurteilungskriterium unterzogen, anhand dessen festgestellt wird, ob die kontrollierte Scheibe WF als "in Ordnung" klassifiziert wird oder als fehlerhaft.

Bei der Kontrolle einer Mehrzahl von Scheiben WF, d. h. einer Charge von Scheiben WF, werden anschließend an die Kontrolle die fehlerhaften Scheiben von den fehlerfreien Scheiben abgesondert und entweder verworfen oder nachbearbeitet.

Nach den folgenden Beurteilungskriterien wird beurteilt, ob die kontrollierte Halbleiterscheibe WF in Ordnung ist oder nicht:

Ein erstes Beurteilungskriterium ist das Maß an Übereinstimmung (bzw. Nichtübereinstimmung), das die jeweiligen ermittelten und zwischengespeicherten Werte des Reflexionsgrades R mit einem jeweils zugeordneten Vergleichswert aufweisen. Zwar werden in der Praxis die jeweiligen Werte und Vergleichswerte nie exakt übereinstimmen, jedoch ist eine möglichst große Übereinstimmung anzustreben. Insoweit ist ein (möglichst kleiner) Toleranzwert vorzusehen.

Ein zweites Beurteilungskriterium wird dem ersten Beurteilungskriterium nachgeschaltet werden:

Wenn die Kontrolle nach dem ersten Beurteilungskriterium (zunächst) ergibt, daß die Scheibe WF fehlerhaft ist, wird die Lage derjenigen Punkte auf der Scheibe WF, deren zugehörigen Bildpunkte Pixel das erste Beurteilungskriterium überschreiten, ermittelt. Daraus wird dann abgeleitet, welche Punkte zusammenhängende Gebiete Reg auf der Scheibe WF bilden (üblicherweise betreffen Fehler aufgrund ihrer benötigten Fläche mehrere Punkte, nicht nur einen einzigen).

Dieses zweite Beurteilungskriterium besagt nun, daß die Anzahl und/oder die Größe solcher zusammenhängender Gebiete Reg ein vorgegebenes Höchstmaß nicht überschreiten darf. Wenn dieses Höchstmaß überschritten wird, wird die Scheibe WF weiterhin als fehlerhaft beurteilt, ansonsten als in Ordnung befunden.

Weiterhin wird jede Scheibe WF dem Verfahren nochmals unterzogen wird unter den beiden folgenden, veränderten Bedingungen:

Die Scheibe wird indirekt beleuchtet (s. Fig. 2 und 3) und die Bildaufnahmeeinrichtung CAM bzw. CAM2 wird in einem weiteren Winkel β zur Oberfläche der Scheibe WF angeordnet, der verschieden ist vom Winkel α. Sinn dieser nochmaligen Kontrolle unter veränderten Bedingungen ist es, Fehler zu finden, die sich bei direkter Beleuchtung und/oder unter dem Aufnahmewinkel α nicht erkennen lassen, jedoch unter entsprechend geänderten Bedingungen.

Gemäß einem dritten Beurteilungskriterium wird eine Scheibe WF, die nach wenigstens einem der beiden zweiten Beurteilungskriterien als in Ordnung befunden worden ist, trotzdem als fehlerhaft klassifiziert, wenn die gesamte Fläche SQ, die alle zusammenhängenden Gebiete Reg der zu kontrollierenden Scheibe WF aufweisen, einen vorgegebenen Anteil an der Gesamtfläche der Scheibe WF überschreitet.

Gemäß einem vierten Beurteilungskriterium (siehe Figur 6) wird eine Scheibe WF, die nach wenigstens einem der beiden zweiten Beurteilungskriterien als in Ordnung befunden worden ist, trotzdem als fehlerhaft klassifiziert, wenn bei wenigstens einem dieser zusammenhängenden Gebiete Reg eine Gerade als fiktive Meßlinie Ln durchlegbar ist, die fiktiv in Abschnitte Sec eingeteilt ist und wenn entlang wenigstens eines dieser Abschnitte Sec die Anzahl von Punkten, deren Werte des Reflexionsgrades R das erste Beurteilungskriterium überschreiten, größer ist als ein gegebener Maximalwert, der längs des jeweiligen Abschnittes Sec dieser Meßlinie Ln bezogen ist auf die Gesamtzahl der Punkte, deren Werte des Reflexionsgrades R zwischengespeichert worden ist.

Bei einem fünften Beurteilungskriterium (siehe Figur 7) wird praktisch geprüft, ob sich die Werte des Reflexionsfaktors R bei einander benachbarten Punkten, von denen der eine dem ersten Beurteilungskriterium genügt und der andere nicht, abrupt ändern. Dieses fünfte Beurteilungskriterium wird angewendet auf solche Scheiben WF, die den beschriebenen zweiten bis vierten Beurteilungskriterien genügen, d. h. also, die nach diesen Beurteilungskriterien als gut bewertet werden.

Bei einer solchen Scheibe WF wird bei einem zusammenhängenden Gebiet Reg in einem Grenzbereich Lim1 dieses Gebietes Reg zu Scheibenbereichen außerhalb dieses Gebietes Reg geprüft, ob die aus Punkten dieses Grenzbereiches Lim1 ermittelten Werte des Reflexionsgrades R sich um mindestens den Faktor 10 von solchen Werten des Reflexionsgrades R unterscheiden, die bezüglich Punkten ermittelt wurden, die sich in einem weiteren Grenzbereich Lim2 außerhalb des Gebietes Reg befinden. Wenn dies der Fall ist, wird die Scheibe als fehlerhaft bewertet.

Wenn Scheiben WF in einem Teilbereich Reg1 strukturierte Einheiten CH aufweisen (z. B. Halbleiterchips einer Halbleiterscheibe; in diesem Fall gibt es sog. Randbereiche, in denen ein Chip nicht mehr vollständig unterbringbar ist aus Platzgründen; dabei werden diese Randbereiche heutzutage meist frei von Chips gelassen), hat es sich als vorteilhaft erwiesen, wenn für die Grenzwerte, die bei den zuvor beschriebenen Beurteilungskriterien verwendet werden, in demjenigen Teil der Scheibe WF, der außerhalb des Bereiches Reg1 mit den strukturierten Einheiten CH liegt, bezüglich der Entscheidung

"Fehler: ja oder nein?" schärfere Grenzwerte verwendet werden als für diejenigen Grenzwerte, die Punkte des Teilbereiches Reg1 betreffen.

Die Anordnung, die den Fig. 2 und 3 entspricht, ist ausführlich in den genannten prioritätsälteren deutschen Patentanmeldungen beschrieben, worauf aus Gründen der Offenbarung ausdrücklich nochmals verwiesen wird (zu beachten ist dabei allerdings, daß der dort verwendete Winkel α dem Winkel β nach den Fig. 2 und 3 der vorliegenden Erfindung entspricht und daß der vorliegend mit "α" bezeichnete Winkel in diesen Anmeldungen bezüglich der Figuren 1 und 2 als rechter Winkel ("senkrecht") dargestellt und beschrieben ist).

In einem Fall (was i. A. der häufigere Fall sein wird), in dem bei der Ermittlung der Vergleichswerte die Vergleichsscheibe eine bestimmte Ausrichtung (Orientierung) erfahren hat (z. B. Ausrichtung am Flat Ft einer Halbleiterscheibe), ist es günstig, auch die zu kontrollierende Scheibe WF entsprechend auszurichten, weil dann die Werte des Reflexionsgrades R ohne besondere Koordinatenumrechnung (bzgl. der Orientierung der Scheibe WF) direkt miteinander verglichen werden können.

Allerdings ist es erfindungsgemäß auch möglich, in dem Fall, in dem die zu kontrollierende Scheibe WF anders ausgerichtet ist als die Vergleichsscheibe oder gar nicht, die Werte des Reflexionsgrades R der zu kontrollierenden Scheibe WF (bzw. die der Vergleichsscheibe) mittels einer entsprechenden, die unterschiedliche Ausrichtung korrigierende Koordinatentransformation so umzuordnen, daß sie lagemäßig der Ausrichtung der Vergleichsscheibe (bzw. der zu kontrollierenden Scheibe WF) entsprechen.

## Patentansprüche

1. Verfahren zur Kontrolle von Scheiben (WF), die eine Lackschicht (L) aufweisen, das automatisch mit folgenden Verfahrensschritten ausgeführt wird:
1) die Scheibe (WF) wird direkt beleuchtet, so daß die Lackschicht (L) das Licht (Lt) reflektiert,
2) mittels einer Bildaufnahmeeinrichtung (CAM), die aufzunehmende Bilder bildpunktweise (Pixel) erfaßt und die in einem gegebenen Winkel (α) über der Scheibe (WF) angeordnet ist, und einer daran angeschlossenen Auswerteeinrichtung (PC) wird für eine Mehrzahl von Punkten der Oberfläche der Scheibe (WF) der Wert des Reflexionsgrades (R) des reflektierten Lichtes (Lt) bildpunktweise (Pixel) ermittelt und zwischengespeichert,
3) die ermittelten und zwischengespeicherten Werte des Reflexionsgrades (R) werden mit vorgegebenen Vergleichswerten verglichen,
4) anhand des Ergebnisses des Vergleichs zwischen den ermittelten und zwischengespeicherten Werten des Reflexionsgrades (R) und den Vergleichswerten wird nach wenigstens einem vorgegebenen Beurteilungskriterium ermittelt, ob die Scheibe (WF) in Ordnung oder fehlerhaft ist,
**gekennzeichnet durch**
folgende Verfahrensschritte:
5) als ein erstes Beurteilungskriterium wird ein vorgegebenes Mindestmaß an Übereinstimmung zwischen einem jeweiligen ermittelten und zwischengespeicherten Wert des Reflexionsgrades (R) und dem diesem zugeordneten Vergleichswert verwendet,
6) im Rahmen eines zweiten Beurteilungskriteriums wird folgendermaßen vorgegangen:
- in dem Fall, in dem das erste Beurteilungskriterium ergibt, daß die Scheibe (WF) fehlerhaft ist, wird die Lage derjenigen Punkte auf der Scheibe (WF) ermittelt, deren Bildpunkte (Pixel) dieses Beurteilungskriterium überschreiten,
- aus der Lage dieser Punkte wird ermittelt, welche davon zusammenhängende Gebiete (Reg) auf der Scheibe (WF) bilden, und
- in dem Fall, in dem die Anzahl und/oder die Größe der zusammenhängenden Gebiete (Reg) ein vorgegebenes Höchstmaß unterschreitet, wird die Scheibe (WF) als in Ordnung befunden,
7) wurde die Scheibe (WF) als fehlerhaft befunden, so wird sie in dem Fall, in dem eine Mehrzahl von Scheiben (WF) kontrolliert wird, von solchen Scheiben (WF) abgesondert, die als fehlerfrei befunden wurden,
8) im Anschluß an die vorhergehenden Verfahrensschritte
- wird die Scheibe (WF) indirekt beleuchtet,
- wird die Bildaufnahmeeinrichtung (CAM) in einem weiteren Winkel (β) zur Oberfläche der Scheibe (WF), der verschieden ist vom gegebenen Winkel (α), angeordnet, und
- werden mittels dieser Anordnung der Bildaufnahmeeinrichtung (CAM) die Verfahrensschritte wenigstens nach den Merkmalen 2) bis 4) durchgeführt.

2. Verfahren nach Anspruch 1,
**dadurch gekennzeichnet, daß** nur solche Scheiben (WF) mittels indirekter Beleuchtung und der im weiteren Winkel (β) angeordneten Bildaufnahmeeinrichtung (CAM) kontrolliert werden, die bei der Kontrolle mittels direkter Beleuchtung und der im gegebenen Winkel (α) angeordneten Bildaufnahmeeinrichtung (CAM) als in Ordnung befindlich erkannt worden sind.

3. Verfahren nach einem der Ansprüche 1 bis 2,
**dadurch gekennzeichnet, daß** in dem Fall, in dem den Vergleichswerten eine bestimmte Ausrichtung einer bei der Ermittlung der Vergleichswerte verwendeten Vergleichsscheibe zugrunde liegt, die zu kontrollierende Scheibe (WF) entsprechend dieser Ausrichtung ausgerichtet wird.

4. Verfahren nach einem der Ansprüche 1 bis 2,
**dadurch gekennzeichnet, daß** in dem Fall, in dem den Vergleichswerten eine bestimmte Ausrichtung einer bei der Ermittlung der Vergleichswerte verwendeten Vergleichsscheibe zugrunde liegt, eine dazu unterschiedliche Ausrichtung der zu kontrollierenden Scheibe (WF) durch entsprechende Koordinatentransformation der Bildpunkte, deren Werte des Reflexionsgrades (R) aufzunehmen sind, ausgeglichen wird.

5. Verfahren nach einem der vorhergehenden Ansprüche,
**dadurch gekennzeichnet, daß** im Rahmen eines dritten Beurteilungskriteriums folgendermaßen vorgegangen wird:
eine nach einem der beiden zweiten Beurteilungskriterien als in Ordnung befundene Scheibe (WF) wird insgesamt als fehlerhaft beurteilt, wenn die Gesamtzahl von zusammenhängenden Gebieten (Reg) mit ihrer gesamten Fläche (SQ), die diese Gebiete (Reg) auf der Scheibe (WF) einnehmen, einen vorgegebenen Anteil an der Gesamtfläche der Scheibe (WF) überschreitet.

6. Verfahren nach einem der vorhergehenden Ansprüche,
**dadurch gekennzeichnet, daß** im Rahmen eines vierten Beurteilungskriteriums folgendermaßen vorgegangen wird:
eine nach einem der beiden zweiten Beurteilungskriterium als in Ordnung befundene Scheibe (WF) wird insgesamt als fehlerhaft beurteilt, wenn bei wenigstens einem der zusammenhängenden Gebiete (Reg) eine Gerade als fiktive Meßlinie (Ln) durchlegbar ist und wenn, entlang wenigstens eines Abschnittes (Sec) dieser Meßlinie (Ln), die Anzahl von Punkten, deren Werte des Reflexionsgrades (R) das erste Beurteilungskriterium überschreiten, größer ist als ein gegebener Maximalwert, der längs des jeweiligen Abschnitts (Sec) dieser Meßlinie (Ln) auf die Gesamtzahl der Punkte, deren Werte des Reflexionsgrades (R) ermittelt worden sind, bezogen ist.

7. Verfahren nach einem der vorhergehenden Ansprüche,
**dadurch gekennzeichnet, daß** im Rahmen eines fünften Beurteilungskriteriums folgendermaßen vorgegangen wird:
in dem Fall, in dem eine Scheibe (WF) nach den Bestimmungen eines der zweiten, dritten oder vierten Beurteilungskriterien als in Ordnung zu bewerten ist, wird die Scheibe (WF) als fehlerhaft bewertet, wenn bei einem zusammenhängenden Gebiet (Reg) Punkte in einem Grenzbereich (Lim1) dieses Gebietes (Reg) Werte des Reflexionsgrades (R) aufweisen, die sich wenigstens um den Faktor 10 von Werten des Reflexionsgrades (R) unterscheiden, die sich für Punkte ergeben, die sich außerhalb dieses und anderer zusammenhängender Gebiete (Reg) in einem weiteren Grenzbereich (Lim2) um das Gebiet (Reg) befinden.

8. Verfahren nach einem der vorhergehenden Ansprüche,
**dadurch gekennzeichnet, daß** in dem Fall, in dem die Scheibe (WF) in einem Teilbereich (Reg1) strukturierte Einheiten (CH) aufweist, außerhalb dieses Teilbereiches (Reg1) die Beurteilung, ob die Scheibe (WF) in Ordnung oder fehlerhaft ist, mit schärferen Kriterien erfolgt als innerhalb dieses Teilbereiches (Reg1).

## Claims

1. Process for checking discs or wafers (WF) which have a coating (L), which is performed automatically with the following method steps:
1) the disc (WF) is illuminated directly, so that the coating (L) reflects the light (Lt),
2) the value of the degree of reflection (R) of the reflected light (Lt) is determined and buffer-stored for a plurality of points of the surface of the disc (WF) on the basis of picture elements (pixels) by means of a picture-taking device (CAM), which captures the pictures to be taken on the basis of picture elements (pixels) and which is arranged at a given angle (α) above the disc (WF), and an evaluating device (PC) connected to said picture-taking device,
3) the determined and buffer-stored values of the degree of reflection (R) are compared with predetermined comparison values,
4) on the basis of the result of the comparison between the determined and buffer-stored values of the degree of reflection (R) and the comparison values, it is determined according to at least one predetermined assessment criterion whether the disc (WF) is in order or defective,
**characterized by** the following method steps:
5) a predetermined minimum degree of coincidence between a respective determined and buffer-stored value of the degree of reflection (R) and the comparison value assigned to it is used as a first assessment criterion,
6) the following procedure is followed within the scope of a second assessment criterion:
- in the case in which the first assessment criterion indicates that the disc (WF) is defective, the position of those points on the disc (WF) for which the picture elements (pixels) exceed this assessment criterion is determined,
- it is determined from the position of these points which of them form contiguous regions (Reg) on the disc (WF), and
- in the case in which the number and/or the size of the contiguous regions (Reg) is below a predetermined maximum amount, the disc (WF) is found to be in order,
7) in the case in which a plurality of discs (WF) are being checked, if the disc (WF) was found to be defective it is segregated from those discs (WF) found to be defect-free,
8) following the preceding method steps,
- the disc (WF) is illuminated indirectly,
- the picture-taking device (CAM) is arranged at a further angle (β), which is different from the given angle (α), in relation to the surface of the disc (WF) and
- the method steps at least according to features 2) to 4) are carried out by means of this arrangement of the picture-taking device (CAM).

2. Process according to Claim 1, **characterized in that** only those discs (WF) which have been found to be in order in the check by means of direct illumination and the picture-taking device (CAM) arranged at the given angle (α) are checked by means of indirect illumination and the picture-taking device arranged at the further angle (β).

3. Process according to either of Claims 1 and 2, **characterized in that**, in the case in which the comparison values are based on a specific alignment of a comparison disc used in the determination of the comparison values, the disc (WF) to be checked is arranged in a way corresponding to this alignment.

4. Process according to either of Claims 1 and 2, **characterized in that**, in the case in which the comparison values are based on a specific alignment of a comparison disc used in the determination of the comparison values, a different alignment of the disc (WF) to be checked is compensated by corresponding coordinate transformation of the picture elements for which values of the degree of reflection (R) are to be recorded.

5. Process according to one of the preceding claims, **characterized in that** the following procedure is followed within the scope of a third assessment criterion:
a disc (WF) found to be in order according to one of the two second assessment criteria is assessed overall as defective if the total number of contiguous regions (Reg) exceeds with its total surface area (SQ) which these regions (Reg) take up on the disc (WF) a predetermined proportion of the total surface area of the disc (WF).

6. Process according to one of the preceding claims, **characterized in that** the following procedure is followed within the scope of a fourth assessment criterion:
a disc (WF) found to be in order according to one of the two second assessment criteria is assessed overall as defective if in the case of at least one of the contiguous regions (Reg) a straight line can be taken through as a fictitious measuring line (Ln) and if along at least a section (Sec) of this measuring line (Ln) the number of points for which values of the degree of reflection (R) exceed the first assessment criterion is greater than a given maximum value, which is based on the total number of points for which values of the degree of reflection (R) have been determined along the respective section (Sec) of this measuring line (Ln).

7. Process according to one of the preceding claims, **characterized in that** the following procedure is followed within the scope of a fifth assessment criterion:
in the case in which a disc (WF) is to be assessed as in order according to the determinations of one of the second, third or fourth assessment criteria, the disc (WF) is assessed as defective if in the case of a contiguous region (Reg) points in a limiting area (Lim1) of this region (Reg) have values for the degree of reflection (R) which differ at least by a factor of 10 from values for the degree of reflection (R) which are obtained for points which are located outside this and other contiguous regions (Reg) in a further limiting area (Lim2) around the region (Reg).

8. Process according to one of the preceding claims, **characterized in that** in the case in which the disc (WF) has structured units (CH) in a subregion (Regl), the assessment as to whether the disc (WF) is in order or defective takes place with stricter criteria outside this subregion (Regl) then within this subregion (Reg1).

## Revendications

1. Procédé pour contrôler des disques (WF) comportant une couche de vernis (L), qui est automatiquement mis en oeuvre avec les étapes suivantes :
1) le disque (WF) est directement éclairé, de sorte que la couche de vernis (L) réfléchit la lumière (Lt),
2) à l'aide d'un dispositif d'enregistrement d'image (CAM), qui saisit point par point (pixels) les images à enregistrer, et qui est disposé selon un angle prédéfini (α) au-dessus du disque (WF), et aussi à l'aide d'un dispositif d'évaluation (PC) qui y est connecté, on détermine point par point (pixels) et on mémorise d'une manière intermédiaire, pour un grand nombre de points de la surface du disque (WF), la valeur du facteur de réflexion (R) de la lumière réfléchie (It),
3) les valeurs du facteur de réflexion (R) déterminées et mémorisées d'une manière intermédiaire sont comparées aux valeurs comparatives prédéfinies,
4) à l'aide du résultat de la comparaison entre les valeurs déterminées et mémorisées d'une manière intermédiaire du facteur de réflexion (R) et les valeurs comparatives, on détermine, en utilisant un critère d'évaluation prédéfini, si le disque (WF) est conforme ou défectueux,
**caractérisé par** les étapes suivantes :
5) en tant que premier critère d'évaluation, on utilise une valeur minimale prédéfinie de la concordance entre une valeur déterminée et mémorisée d'une manière intermédiaire du facteur de réflexion (R), et la valeur comparative qui lui est affectée,
6) dans le cadre d'un deuxième critère d'évaluation, on procède comme suit :
- dans le cas dans lequel le premier critère d'évaluation dit que le disque (WF) est défectueux, on détermine la position des points du disque (WF) dont les points images (pixels) dépassent ce critère d'évaluation,
- à partir de la position de ces points, on détermine ceux qui, sur le disque (WF), forment des régions continues (Reg), et
- dans le cas dans lequel le nombre et/ou la taille des régions continues (Reg) sont inférieurs à une valeur maximale prédéfinie, le disque (WF) est considéré comme conforme,
7) si le disque (WF) s'est révélé défectueux, il va, dans le cas dans lequel on contrôle un grand nombre de disques (WF), être séparé des disques (WF) qui ont été considérés comme défectueux,
8) après les étapes ci-dessus :
- le disque (WF) est soumis à un éclairage indirect,
- le dispositif d'enregistrement d'image (CAM) est disposé selon un autre angle (β) par rapport à la surface du disque (WF), qui est différent de l'angle (α) prédéfini, et
- on procède, à l'aide de cette disposition du dispositif d'enregistrement d'image (CAM), aux étapes au moins selon les caractéristiques 2) à 4).

2. Procédé selon la revendication 1, **caractérisé en ce que** seuls sont contrôlés, à l'aide d'un éclairage indirect et du dispositif d'enregistrement d'image (CAM) disposé selon l'autre angle (β), les disques WF qui, lors du contrôle par éclairage direct et faisant appel au dispositif d'enregistrement d'image (CAM) disposé selon l'angle (α) prédéfini, ont été reconnus comme étant conformes.

3. Procédé selon l'une des revendications 1 à 2, **caractérisé en ce que**, dans le cas dans lequel les valeurs comparatives se fondent sur une certaine orientation d'un disque comparatif utilisé lors de la détermination des valeurs comparatives, le disque (WF) à contrôler est orienté selon cette orientation.

4. Procédé selon l'une des revendications 1 à 2, **caractérisé en ce que**, dans le cas dans lequel les valeurs comparatives se fondent sur une certaine orientation d'un disque comparatif utilisé lors de la détermination des valeurs comparatives, une orientation qui en est différente du disque (WF) à contrôler est compensée par une transformation correspondante des coordonnées des points images dont il s'agit d'enregistrer la valeur du facteur de réflexion (R).

5. Procédé selon l'une des revendications précédentes, **caractérisé en ce que**, dans le cadre d'un troisième critère d'évaluation, on procède comme suit :
un disque (WF) qui a été considéré comme conforme d'après l'un des deux deuxièmes critères d'évaluation, est globalement évalué comme étant défectueux quand le nombre total des régions continues (Reg) a une aire totale (SQ), qui englobe ces régions (Reg) sur le disque (WF), supérieure à une portion prédéfinie de l'aire totale du disque (WF).

6. Procédé selon l'une des revendications précédentes, **caractérisé en ce que**, dans le cadre d'un quatrième critère d'évaluation, on procède comme suit :
un disque (WF) qui a été considéré comme conforme d'après l'un des deux deuxièmes critères d'évaluation est globalement évalué comme étant défectueux quand, pour au moins l'une des régions continues (Reg) il est possible de tracer une droite sous forme d'une ligne de mesure fictive (Ln), et si, le long d'au moins un segment (Sec) de cette ligne de mesure (Ln), le nombre des points dont la valeur du facteur de réflexion (R) dépasse le premier critère d'évaluation est supérieur à une valeur maximale prédéfinie, qui le long du segment considéré (Sec) de cette ligne de mesure (Ln) est rapportée au nombre total des points dont la valeur du facteur de réflexion (R) a été déterminée.

7. Procédé selon l'une des revendications précédentes, **caractérisé en ce que**, dans le cadre d'un cinquième critère d'évaluation, on procède comme suit :
dans le cas dans lequel un disque (WF) doit, d'après les règles de l'un des deuxième, troisième ou quatrième critères d'évaluation, être évalué comme conforme, le disque (WF) est considéré comme défectueux quand, dans une région continue (Reg), les points se trouvant dans un domaine limite (Lim1) de cette région (Reg) présentent des valeurs du facteur de réflexion (R) qui se distinguent d'un facteur au moins égal à 10 des valeurs du facteur de réflexion (R) que l'on obtient pour les points qui se trouvent à l'extérieur de cette région continue et d'autres régions continues (Reg) dans un autre domaine limite (Lim2) qui entoure la région (Reg).

8. Procédé selon l'une des revendications précédentes, **caractérisé en ce que**, dans le cas dans lequel le disque (WF) comporte dans un domaine partiel (Reg1) des unités structurées (CH), l'évaluation permettant de savoir si le disque (WF) est conforme ou défectueux est, à l'extérieur de ce domaine partiel (Reg1), mise en oeuvre avec des critères plus sévères qu'à l'intérieur de ce domaine partiel (Reg1).
